**Europäisches Patentamt**

**European Patent Office**

**Office européen des brevets**

(19)

(11) Veröffentlichungsnummer: **0 034 322**
**B1**

(12)

# EUROPÄISCHE PATENTSCHRIFT

(45) Veröffentlichungstag der Patentschrift:
**08.01.86**

(51) Int. Cl.⁴: **H 03 K 3/72**, H 03 K 3/017,
H 04 B 11/00

(21) Anmeldenummer: **81100902.6**

(22) Anmeldetag: **09.02.81**

(54) **Ultraschall-Sender.**

(30) Priorität: **19.02.80 DE 3006106**

(43) Veröffentlichungstag der Anmeldung:
**26.08.81 Patentblatt 81/34**

(45) Bekanntmachung des Hinweises auf die Patenterteilung:
**08.01.86 Patentblatt 86/2**

(84) Benannte Vertragsstaaten:
**AT CH DE FR GB LI NL**

(56) Entgegenhaltungen:
**DE - A - 2 856 840**
**DE - B - 1 038 111**
**GB - A - 1 389 257**
**US - A - 3 812 709**

**ELEKTRONIK, Band 27, Nr. 14, Dezember 1978,**
**München, DE., H. ALT: "Intervallschalter mit getrennt**
**einstellbarer Pulszeit und Pulszahl"**

(73) Patentinhaber: **Siemens Aktiengesellschaft, Berlin und**
**München Wittelsbacherplatz 2, D-8000 München 2 (DE)**

(72) Erfinder: **Rost, Helmut, Dipl.-Ing.,**
**Simon-Dach-Strasse 8, D-8521 Uttenreuth (DE)**
Erfinder: **Walz, Alfred, Tannenweg 14, D-8501 Burgthann**
**(DE)**

## Beschreibung

Die Erfindung bezieht sich auf einen Ultraschall-Sender zur Erzeugung von jeweils eine Anzahl von Erregungsimpulsen umfassenden Sendeimpulsen für einen Ultraschall-Wandler, mit einem von einem Pulstaktgeber angesteuerten Zähler, der mit einem Programmiereingang versehen ist, und mit einem Bauelement, an dessen Einstelleingang die Anzahl der Erregungspulse pro Sendeimpuls einstellbar ist.

Ultraschall-Sender sollen bezüglich des Betriebes von Ultraschall-Wandlern möglichst vielseitig ausgelegt sein. Sie sollen nicht nur für unterschiedlichste Arten von Wandlersystemen, wie beispielsweise für Schallköpfe mit nur einem einzigen oder einer geringen Zahl von Schwingelementen oder für ganze Wandlerkämme (sogenannte Arrays), verwendbar sein. Bei ein und derselben Art des verwendeten Wandlersystems ist auch eine rasche Umstellung auf unterschiedliche Betriebsbedingungen, wie beispielsweise unterschiedliche Sendefrequenz, Dauer und/oder Zahl der während der Erregungsphase abzugebenden Pulse, erstrebenswert. Speziell bei Phased Arrays besteht auch der Wunsch nach besonders einfacher und dennoch höchst genauer Einstellung der Verzögerungszeiten. Herkömmliche Geräte aller Art ermöglichen Änderungen der Betriebsweisen insgesamt nur durch Nachstimmen einzelner Schaltungsglieder bei Direkteingriff in die Schaltung oder durch Mehrfachbereitstellung einzelner Schaltungsglieder oder gar ganzer Sendersysteme.

Ein Sender der eingangs genannten Art ist aus der DE-B-1 038 111 bekannt. Es handelt sich dabei um eine Schaltungsanordnung zur Erzeugung von Impulsfolgen mit einstellbaren Impulslängen und Impulsabständen, bei der zwei Zähler verwendet werden, und die z.B. für Fernwirkanlagen od. dgl. vorgesehen ist. Sie erzeugt eine Impulsfolge, deren einzelne Impulse einen wählbaren und vorher festgelegten zeitlichen Abstand besitzen und die auch in ihrer Breite einstellbar sind. Die abgegebene Impulsfolge besitzt eine Anzahl vorher festgelegter Impulse. Der bekannte Impulssender ist nicht für die Anwendung in der Ultraschalltechnik vorgesehen. Die erzeugten Impulse sind daher auch nicht symmetrisch bezüglich der Nullinie. Weiterhin lässt sich eine Frequenzverstellung nicht vornehmen.

Bei der Untersuchung von Spannungen in metallischen Proben ist es bereits bekannt (US-A-3 812 709), Scher- oder Oberflächenwellen im Ultraschall-Frequenzbereich mittels eines Senderkristalls zu erzeugen, der über einen Verstärker von einem HE-Oszillator mit vorgegebener Sendezeit angesteuert wird.

Aufgabe der Erfindung ist es, einen Ultraschall-Sender der eingangs genannten Art so auszugestalten, dass sowohl eine digitale Frequenzsteuerung als auch eine digitale Steuerung der Pulsanzahl des Sendeimpulses jeweils über einen Adresswert möglich ist.

Die Aufgabe wird erfindungsgemäss dadurch gelöst, dass der Zähler ein programmierbarer Zähler ist, an dessen Programmiereingang die Pulsfrequenz in Form eines ersten eingebbaren Digitalwertes einstellbar ist, dass das Bauelement ein auf den Zähler einwirkendes digitales Steuerglied ist, an dessen Einstelleingang die Zahl der dem Ultraschall-Wandler innerhalb eines Sendepulses zuzuführenden Erregungsimpulse und damit auch die Gesamtdauer des Sendepulses in Form eines zweiten eingebbaren Digitalwertes einstellbar ist, dass vom Ausgang des Zählers zwei Flip-Flop-Schaltungen beaufschlagt sind, die zwei bezüglich zur Nullinie asymmetrische Pulskurven abgegeben, welche gegeneinander vorzugsweise um eine Pulsdauer verschoben sind, und dass im Takt der beiden asymmetrischen Pulskurven am Ausgang einer Gegentaktstufe in Abhängigkeit von den beiden eingebbaren Digitalwerten ein vorzugsweise symmetrisch zur Nullinie verlaufender Rechteckpulszug mit begrenzter Anzahl von Rechteckimpulsen erzeugt wird, der als der Sendeimpuls dem Ultraschall-Wandler zugeführt ist.

Die Erfindung erlaubt eine einfache Umstellung der Frequenz des Ultraschall-Senders nach Bedarf; ein Eingriff in den Schaltungsaufbau ist nicht nötig. Damit zeigt der erfindungsgemässe Ultraschall-Sender gute Anpassungsfähigkeit an unterschiedliche Ultraschall-Wandlersysteme mit unterschiedlichen Frequenzbedingungen. Insbesondere bei Fest-Arrays sind hinsichtlich der verzögerten Ansteuerung zeitlich nacheinander erregter Wandlerelemente exakt definierte Verzögerungszeiten gegeben. Der Ultraschall-Sender ist auch in diesem Sinne optimal ausgelegt.

Neben dem als Frequenzsteuerglied verwendeten Zähler ist auch das digitale Steuerglied vorhanden, an dem die Zahl der dem Ultraschall-Wandler innerhalb einer Erregungsphase zuzuführenden Erregungspulse und damit die Gesamtdauer des Sendepulses in Form eines zweiten eingebbaren Digitalwertes einstellbar ist. Gegebenenfalls kann auch noch ein weiteres digitales Steuerglied beigeordnet sein, an dem sich das Tastverhältnis mittels eines weiteren Digitalwertes vorwählen lässt.

Weitere Vorteile und Einzelheiten der Erfindung ergeben sich aus der nachfolgenden Beschreibung eines Ausführungsbeispiels anhand der Zeichnung in Verbindung mit den Unteransprüchen.

Es zeigen:

Fig. 1 und 2 die Erfindung im Prinzipschaltbild,

Fig. 3 ein Impulsdiagramm der wesentlichsten Spannungspulsfolgen.

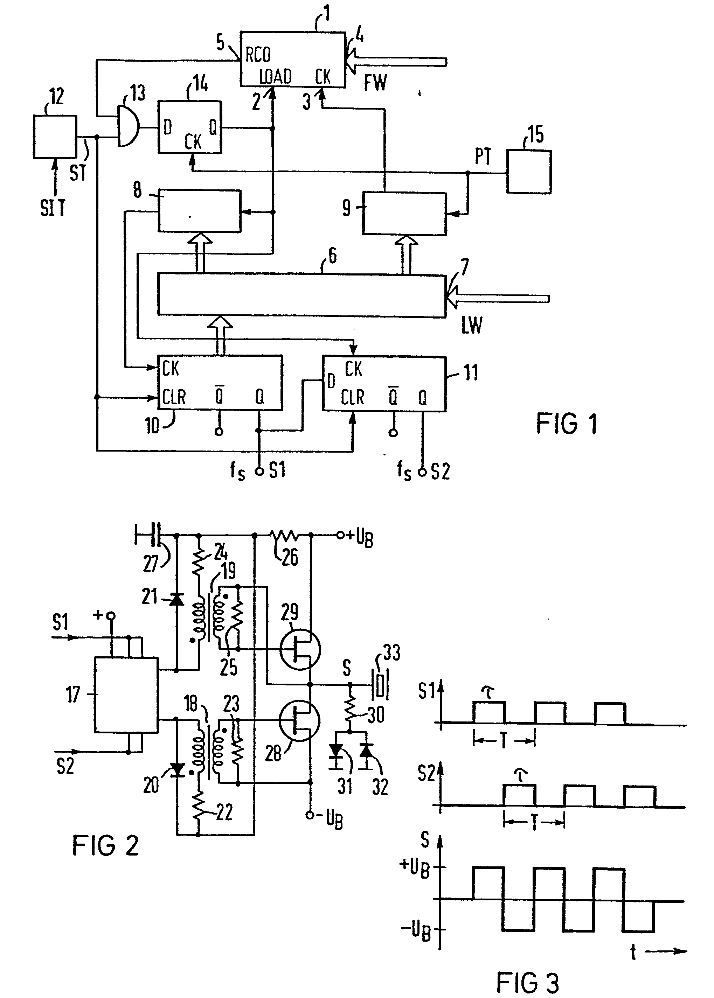

In der Fig. 1 ist mit 1 ein programmierbarer Rückwärtszähler bezeichnet, der zwei Ansteuereingänge 2 und 3 sowie einen Programmiereingang 4 zur Eingabe der gewünschten Frequenz der Erregerimpulse in Form eines Digitalwertes FW umfasst. An einem Signalausgang 5 werden jeweils bei Nulldurchlauf des Rückwärtszählers Überlauf-Impulse abgegeben, deren Anfalltakt dem digital eingegebenen Frequenzwert entspricht. Das Bauteil 6 bezeichnet einen Pulslängen-Multiplexer als digitales Steuerglied, über den wiederum in Form eines eingebbaren Digitalwertes (Adresse LW) an einem Einstelleingang 7 die Pulszahl, die einem Sendepuls insgesamt zuzuordnen ist, eingegeben werden kann. Die digital eingegebene Pulszahl legt dann die Gesamtlänge des Erregungsimpulses fest.

Beiden Bauelementen 1 und 6 sind in der dargestellten Zusammenschaltung elektronische Tore 8 und 9, Teiler-Flip-Flops 10 und 11 sowie eine Startstufe, bestehend aus Startimpulsgeber 12, UND-Gatter 13 und Synchronisier-Flip-Flop 14, zugeordnet. Die Synchronisation erfolgt über den Pulstakt PT eines zentralen Pulstaktgebers 15. Die an den Ausgängen Q der Teiler-Flip-Flops 10 und 11 anfallenden Pulskurven S1(t) und S2(t) sind gegeneinander um eine Pulsdauer $\tau = T/2$ phasenverschoben. Sie haben also die im Diagramm der Fig. 3 aufgezeigten Verläufe mit dem Tastverhältnis 1:1.

Diese Pulse werden schliesslich einer Gegentaktendstufe gemäss Fig. 2 zugeleitet. Die Gegentaktendstufe umfasst eingangsseitig eine Treiberschaltung 17, auf die ausgangsseitig über zwei Schaltungen aus Ringkernbreitbandübertragern 18 und 19, Dioden 20 und 21, ohm'schen Widerständen 22 bis 26 und einer Kapazität 27 zwei im Gegentakt geschaltete Transistoren 28, 29, vorzugsweise V MOS-Feldeffekttransistoren, folgen. Aufgrund der Gegentaktsteuerung dieser Transistoren 28 und 29 ergibt sich eine Rechteckspannung S(t) mit zwischen $+U_B$ und $-U_B$ wechselnder Amplitude. Diese Rechteckspannung S wird dann schliesslich über ein Ausgangsglied, bestehend aus ohm'schem Widerstand 30 sowie gegensinnig gepolten Dioden 31 und 32, einem Ultraschall-Wandler 33 zugeleitet.

Wie eingangs schon erwähnt, kann es sich beim Ultraschall-Wandler 33 um einen Einzelschwinger handeln, der Ultraschall-Impulse aussendet und empfängt (z. B. für A-Scan-Betrieb). Im vorliegenden Falle soll jedoch der Wandler 33 speziell ein einzelnes Wandlerelement eines ganzen Wandlerkammes für B-Scan, z.B. das Element eines Phased Arrays, sein. Je nach Gesamtzahl aller nebeneinander oder auch in Matrixform in Zeilen übereinander angeordneter Wandlerelemente des Arrays ist dann eine entsprechende Zahl von Sender-Stufen gemäss vorliegend beschriebener Form erforderlich. Im Falle der Anwendung bei einem Phased Array werden in einfacher Weise die unterschiedlichen Verzögerungszeiten festgelegt dadurch, dass die Zeitpunkte des Setzens von Startimpulsen am Startimpulsgeber 12 zeitlich unterschiedlich aufeinanderfolgend gewählt sind. Damit sind also die Verzögerungszeiten einfach und exakt jederzeit reproduzierbar. Hinsichtlich der Pulskurven des Diagrammes der Fig. 3 beträgt die Pulsdauer $\tau$ vorzugsweise die halbe Wellenlänge ($\lambda/2$) der Nutzerregungsschwingung für ein Wandlerelement. Beim gewählten Tastverhältnis 1:1 entspricht dann der symmetrische Rechteckpulsverlauf S(t) gemäss Fig. 3 frequenzmässig nach sinusförmiger Verschleifung am jeweiligen Wandlerelement exakt dem Verlauf der Grundwelle des Wandlers. Der Wandler wird damit in seiner Nutzresonanzfrequenz angeregt; der Oberwellenanteil ist kaum noch wirksam. Der Sender gemäss der Erfindung bewirkt damit relativ schmalbandige Erregung des Wandlerelementes. Das gewählte Tastverhältnis 1:1 mit $\lambda/2$ als Pulsdauer schafft also ein Sendesystem mit besonders hohem Wirkungsgrad. Selbstverständlich sind andere Tastverhältnisse, z. B durch Variation von FW während des Aufbaues eines Sendepulszuges, ebenfalls möglich; sie führen jedoch im allgemeinen zu einer Erweiterung der Bandbreite.

Die Funktionsweise der Erfindung gemäss Ausführungsbeispiel der Fig. 1 bis 3 ergibt sich wie folgt:

Vor Inbetriebnahme wird am Eingang 4 des programmierbaren Rückwärtszählers 1 die gewünschte Frequenz als Digitalwert FW eingegeben. Ebenso wird dem Multiplexer 6 ein Adresswort LW für die Pulsanzahl und damit die Gesamtlänge eines Erregungsimpulses zugeführt. Zum Starten eines Sendevorganges wird dann mittels Startimpulsgeber 12 ein Startimpuls ST gesetzt, der über das UND-Gatter 13 auf den Eingang D des Flip-Flops 14 gekoppelt wird. Am CK-Eingang liegt gleichzeitig die Pulskurve PT des zentralen Pulstaktgebers 15. Mit dem Auftreten des ersten Pulses PT dieses zentralen Pulstaktgebers 15 und vorheriger Abgabe des Startimpulses ST wird am Ausgang Q des Flip-Flops 14 ein synchronisierter Startimpuls auf den Steuereingang 2 (LOAD) des Rückwärtszählers 1 gegeben. Der Rückwärtszähler 1 programmiert sich daraufhin selbst mit dem am Eingang 4 anliegenden Frequenzwort FW. Mit abgeschlossener Programmierung beginnt dann auch die Abwärtszählung des Rückwärtszählers 1 im Takt der Impulse PT des zentralen Pulstaktgebers 15, die dem Steuereingang 3 (CK) des Rückwärtszählers 1 über das offene Tor 9 zugeleitet werden. Der abwärtszählende Zähler 1 durchläuft schliesslich nach der einprogrammierten Zahl von FW-Takten die Stellung Null, woraufhin am Ausgang 5 (RCO) ein Überlauf-Impuls erzeugt wird. Dieser Überlauf-Impuls wird über das UND-Gatter 13 wiederum auf den Eingang D des Flip-Flops 14 gegeben. Entsprechend dem vorherigen Startimpuls ST wird auch dieser neue Takt mit dem nächstfolgenden Puls PT des Pulstaktgebers 15 synchronisiert und als weiterer LOAD-Impuls dem Steuereingang 2 des Rückwärtszählers 1 zugeführt. Der Rückwärtszähler 1 programmiert sich dabei erneut mit dem Wert FW, und der Vorgang des Rückwärtszählens mit erneuter Rückkopplung eines Überlauf-Impulses wiederholt sich, wie vorstehend schon beschrieben.

Dies geschieht so lange, bis vom Multiplexer 6 dem Tor 9 ein Sperrimpuls zugeleitet wird. Der Zeitpunkt des Auftretens eines solchen Sperrimpulses ist festgelegt durch das letztmalige Auftreten eines Pulses der mittels Adresswort LW vorgewählten Zahl von Einzelpulsen des Erregungsimpulses. Ist z.B. die Zahl der Pulse, wie in Fig. 3 dargestellt, zu LW gleich 3 vorgewählt, so wird also nach Auftreten des dritten Impulses vom Multiplexer 6 das Tor 9 geschlossen. Es können dann keine weiteren Pulstakte PT des Pulstaktgebers 15 zum Steuereingang 3 des Zählers 1 gelangen, woraufhin der Abwärtszählvorgang gestoppt wird. Ein erneutes Anstossen wird erst wieder durch einen neuen Startimpuls ST am Ausgang des Startimpulsgebers 12 bewirkt.

Der Multiplexer 6 steuert darüber hinaus in Abhängigkeit von der gewählten Pulsanzahl LW und von der Stellung der ausgangsseitigen Frequenzteiler-Flip-Flops 10 und 11 auch noch ein zweites elektronisches Tor 8 für die LOAD-Impulse des Synchronisier-Flip-Flops 14 der Eingangsstartstufe. Das Tor 8 wird vom Multiplexer 6 geöffnet in dem Augenblick, in dem mit Setzen eines Startimpulses ST gleichzeitig auch vom Eingang CLR her die Teiler-Flip-Flops 10 und 11 an den Ausgängen Q auf Null gesetzt sind. Das Tor 8 bleibt dann so lange für LOAD-Signale geöffnet, bis vom Multiplexer 6 am Ende des letzten Pulses der eingegebenen Pulszahl auch dem Tor 8 ein Schliessimpuls zugeführt wird. Während das Teiler-Flip-Flop 10 jetzt sofort für LOAD-Impulse gesperrt ist, erhält das Teiler-Flip-Flop 11 noch einen letzten LOAD-Impuls über die Direktverbindung zum Eingang CK. An den Ausgängen Q erscheinen also bei z.B. vorgewählter Zahl LW = 3 die auf drei Pulse begrenzten phasenverschobenen Pulszüge S1 und S2 gemäss Fig. 3. Diese Pulszüge S1, S2 werden dann schliesslich in der vorstehend schon beschriebenen Weise an der Gegentaktstufe gemäss Fig. 2 in den Rechteckpulszug S(t) umgewandelt.

Gemäss der Erfindung ist der Wert FW für die Frequenz ein Digitalwert. Aus diesem Digitalwert FW formt sich in Verbindung mit dem zentralen Pulstakt PT die Sendepulsfrequenz $f_s$ an den Ausgängen Q der Teiler-Flip-Flops 10 und 11 wie folgt:

$$f_s = \frac{PT}{2\,(FW + 1)}$$

Wird also beispielsweise der zentrale Pulstakt zu PT = 20 MHz gewählt und für FW der Digitalwert für die Zahl 4 eingespeichert, so stellt sich nach vorstehender Beziehung die Sendefrequenz auf $f_s$ = 2 MHz ein. Für andere Werte von FW ergeben sich entsprechend andere Sendefrequenzen $F_s$.

Im Ausführungsbeispiel der Fig. 1 bis 3 kann der Startimpulsgeber 12 seinen Startimpuls ST direkt und unverzögert im erwünschten Aussendetakt von Sendeimpulsen liefern. Es ergibt sich dann beispielsweise für Einzelwandler oder Wandler-Arrays ein normaler unverzögerter Sendebetrieb. Sofern fokussiert werden soll, beispielsweise im Falle eines Phased Arrays, muss verzögert werden. Hierzu sind, wie schon erwähnt, die Startimpulse für die einzelnen Wandlerelemente des Arrays in zeitlicher Aufeinanderfolge unterschiedlich nach einem bestimmten Zeitprofil vorzugeben. Speziell für letzteren Fall ist dann der Startimpulsgeber 12 vorzugsweise ein Programmgeber für ein solches Zeitprofil; er weist also einen Eingang SIT für den eigentlichen Sendeimpulstakt auf und bildet intern entsprechend dem eingespeicherten Verzögerungsprogramm die unterschiedlichen Verzögerungszeiten für die zeitverschobene Abgabe von Startimpulsen ST nach Auftreten zugeordneter Sendetaktimpulse SIT. Der Takt SIT kann wahlweise von einem separaten Impulsgeber oder auch von dem bereits angeführten zentralen Pulstaktgeber 15 abgeleitet sein.

Nach dem Impulsverlauf der Fig. 3 haben die Rechteckimpulse der Sendepulsspannung S(t) dieselben Amplituden. In Modifikation des Ausführungsbeispiels kann aber auch in einfacher Weise eine Amplitudenbelegung nach vorwählbarem Profil vorgenommen werden dadurch, dass die Betriebsspannung $\pm U_B$ der Gegentaktendstufe (Fig. 2) variabel ausgebildet ist. Durch Wahl einer geeigneten Belegung können insbesondere Nebenkeuleneffekte weitgehend unterdrückt werden. Das Ausführungsbeispiel erlaubt in praktischer Ausführung bei einer Versorgungsspannung zwischen $\pm$ 50 V Frequenzänderungen im Bereich 100 kHz bis 10 MHz. Es lässt sich also für alle derzeit verwendeten Wandlersysteme einsetzen.

**Patentansprüche**

1. Ultraschall-Sender zur Erzeugung von jeweils eine Anzahl von Erregungsimpulsen umfassenden Sendeimpulsen (S) für einen Ultraschall-Wandler (33), mit einem von einem Pulstaktgeber (15) angesteuerten Zähler (1), der mit einem Programmiereingang (4) versehen ist, und mit einem Bauelement (6), an dessen Einstelleingang (7) die Anzahl der Erregungspulse pro Sendeimpuls (S) einstellbar ist, dadurch gekennzeichnet, dass der Zähler (1) ein programmierbarer Zähler ist, an dessen Programmiereingang (4) die Pulsfrequenz ($f_s$) in Form eines ersten eingebbaren Digitalwertes (FW) einstellbar ist, dass das Bauelement (6) ein auf den Zähler (1) einwirkendes digitales Steuerglied ist, an dessen Einstelleingang (7) die Zahl der dem Ultraschall-Wandler (33) innerhalb eines Sendepulses (S) zuzuführenden Erregungsimpulse und damit auch die Gesamtdauer des Sendepulses (S) in Form eines zweiten eingebbaren Digitalwertes (LW) einstellbar ist, dass vom Ausgang des Zählers (1) zwei Flip-Flop-Schaltungen (10, 11) beaufschlagt sind, die zwei bezüglich zur Nullinie asymmetrische Pulskurven (S1, S2) abgeben, welche gegeneinander vorzugsweise um eine Pulsdauer ($\tau$) verschoben sind, und dass im Takt der beiden asymmetrischen Pulskurven (S1, S2) am Ausgang einer Gegentaktstufe (17 bis 32) in Abhängigkeit von den beiden eingebbaren Digitalwerten (FW, LW) ein vorzugsweise symmetrisch zur Nullinie verlaufender Rechteckpulszug mit begrenzter Anzahl von Rechteckimpulsen erzeugt wird, der als der Sendeimpuls (S) dem Ultraschall-Wandler (3) zugeführt ist.

2. Ultraschall-Sender nach Anspruch 1, dadurch gekennzeichnet, dass ein weiteres digitales Steuerglied vorgesehen ist, an dem das Tastverhältnis $\tau/(T - \tau)$ der Erregungspulse in Form eines eingebbaren Digitalwertes einstellbar ist.

3. Ultraschall-Sender nach Anspruch 1, dadurch gekennzeichnet, dass die Pulsdauer ($\tau$) der Pulse

der asymmetrischen Pulskurven (S1, S2) gleich der halben Längenwelle (λ/2) der Grundwelle des Ultraschall-Wandlers (33) gewählt ist.

4. Ultraschall-Sender nach Anspruch 3, dadurch gekennzeichnet, dass das Tastverhältnis der asymmetrischen Pulskurven (S1, S2) zu 1:1 gewählt ist.

5. Ultraschall-Sender nach einem der Ansprüche 1 bis 4, dadurch gekennzeichnet, dass der programmierbare Zähler (1) ein Rückwärtszähler ist, der in Abhängigkeit von einem Startimpuls (ST) den ersten eingebbaren Digitalwert (FW) übernimmt und der nach Übernahme des ersten Digitalwerts (FW) im Takt (PT) des Pulstaktgebers (15) herabgezählt wird, wobei er nach jedem Durchlauf einen Überlaufimpuls abgibt, dass das digitale Steuerglied (6) ein Pulslängen-Multiplexer ist, dessen Adresseneingang der Einstelleingang (7) für den zweiten Digitalwert (LW) ist, und dass dem Zähler (1) und dem Pulslängen-Multiplexer (6) elektronische Tore (8, 9), die Flip-Flop-Schaltungen (10, 11) zur Frequenzteilung sowie eine Startstufe, die einem Startimpulsgeber (12) zur Abgabe des Startimpulses (ST), ein UND-Gatter (13) und ein Synchronisier-Flip-Flop (14) umfasst, zugeordnet ist.

6. Ultraschall-Sender nach Anspruch 5, dadurch gekennzeichnet, dass ein erster Eingang des UND-Gatters (13) mit dem Startimpulsgeber (12) zur Beaufschlagung mit den Startimpulsen (ST) verbunden ist, und dass ein zweiter Eingang des UND-Gatters (13) an den Ausgang (5) des Rückwärtszählers (1) angeschlossen ist, dass die Überlaufimpulse, die jeweils beim Nulldurchgang des Rückwärtszählers (1) erzeugt werden, über das UND-Gatter (13) dem Eingang des Synchronisier-Flip-Flops (14) zugeleitet werden, und dass die über das UND-Gatter (13) dem Synchronisier-Flip-Flop (14) zugeleiteten Startimpulse (ST) und die vom Ausgang des Rückwärtszählers (1) über das UND-Gatter (13) dem Synchronisier-Flip-Flop (14) zugeleiteten Überlaufimpulse durch das Synchronisier-Flip-Flop (14) mit dem Pulstakt (PT) des zentralen Pulstaktgebers (15) zu synchronisierten Startimpulsen für den Rückwärtszähler (1) synchronisiert werden.

7. Ultraschall-Sender nach Anspruch 6, dadurch gekennzeichnet, dass der Zähltakt des Rückwärtszählers (1) gleichzeitig auch der Pulstakt (PT) des zentralen Pulstaktgebers (15) ist, wobei die zentralen Pulstakte (PT) zum Rückwärtszählen dem Rückwärtszähler (1) über ein erstes elektronisches Tor (9) zugeleitet sind, das durch ein Steuersignal des Pulslängen-Multiplexers (6) für die zentralen Pulstakte (PT) schliessbar ist in dem Augenblick, in dem der letzte Puls der über den zweiten Digitalwert (LW) in den Pulslängen-Multiplexer (6) eingegebenen Pulszahl angefallen ist.

8. Ultraschall-Sender nach Anspruch 7, dadurch gekennzeichnet, dass der Pulslängen-Multiplexer (6) auch ein zweites elektronisches Tor (8) steuert, durch welches die synchronisierten Startimpulse vom Ausgang des Synchronisier-Flip-Flops (14) zur ersten Flip-Flop-Schaltung (10) geleitet sind, während die synchronisierten Startimpulse der zweiten Flip-Flop-Schaltung (11) direkt zugeführt sind.

9. Ultraschall-Sender nach Anspruch 8, dadurch gekennzeichnet, dass auch das zweite Tor (8) durch den Pulslängen-Multiplexer (6) schliessbar ist, sobald der letzte Puls entsprechend dem am Pulslängen-Multiplexer (6) eingegebenen ersten Digitalwert (LW) angefallen ist, so dass die erste Flip-Flop-Schaltung (10) ab sofort für synchronisierte Startimpulse des Synchronisier-Flip-Flops (14) gestoppt ist, während die zweite Flip-Flop-Schaltung (11) über die Direktleitung noch einen allerletzten synchronisierten Startimpuls erhält.

10. Ultraschall-Sender nach einem der Ansprüche 1 bis 9, dadurch gekennzeichnet, dass sich die an den Ausgängen (Q) der Flip-Flop-Schaltungen (10, 11) ergebende Sendepulsfrequenz (f$_s$) in Abhängigkeit vom ersten Digitalwert (FW) am Zähler (1) und vom zentralen Pulstakt (PT) des Pulstaktgebers (15) nach der Beziehung

$$f_s = \frac{PT}{2\,(FW + 1)}$$

ergibt.

**Claims**

1. An ultrasonic transmitter for the generation of transmitted pulses (S), which each comprise a number of excitation pulses for an ultrasonic transducer (33), with a counter (1) driven by a clock-pulse generator (15) and provided with a programming input (4), and with a component (6) at whose setting input (7) the number of excitation pulses per transmitted pulse (S) can be adjusted, characterised in that the counter (1) is a programmable counter at whose programming input (4) the pulse frequency (f$_s$) can be adjusted to form a first input digital value (FW), that the component (6) represents a digital control component which acts upon the counter (1) and at whose setting input (7) it is possible to adjust the number of excitation pulses to be supplied to the ultrasonic transducer (33) within a transmitted pulse (S) and thus also the overall duration of the transmitted pulse (S) to form a second input digital value (LW), that the output of the counter (1) is connected to two flip-flop circuits (10, 11) which emit two pulse waveforms (S1, S2) which are asymmetrical relative to the zero line and displaced from one another, preferably by a pulse duration (τ), and that in the timing of the two asymmetrical pulse waveforms (S1, S2), at the output of a push-pull stage (17 to 32), in dependence upon the two input digital values (FW, LW), a rectangular pulse train is produced symmetrical to the zero line and contains a limited number of rectangular pulses and is fed as the transmitted pulse (S) to the ultrasonic transducer (3).

2. An ultrasonic transmitter as claimed in Claim 1, characterised in that a further digital control element is provided on which the pulse duty factor τ/(T − τ) of the excitation pulses can be set in the form of an input digital value.

3. An ultrasonic transmitter as claimed in Claim 1, characterised in that the pulse duration ($\tau$) of the pulses of the asymmetrical pulse waveforms (S1, S2) is selected to be equal to a half-wavelength ($\lambda/2$) of the fundamental wave of the ultrasonic transducer (33).

4. An ultrasonic transmitter as claimed in Claim 3, characterised in that the pulse duty factor of the asymmetrical pulse waveforms (S1, S2) is selected to be 1:1.

5. An ultrasonic transmitter as claimed in one of Claims 1 to 4, characterised in that the programmable counter (1) is a backwards counter which receives the first input digital value (FW) in dependence upon the start pulse (ST) and which, following the transfer of the first digital value (FW), counts downwards in the timing (PT) of the clock-pulse generator (15), and following each cycle emits an overflow pulse, that the digital control element (6) is a pulse-length multiplexer whose address input is the setting input (7) of the second digital value (LW), and that the counter (1) and the pulse-length multiplexer (6) are assigned electronic gates (8, 9), the flip-flop circuits (10, 11) for the frequency division, and a start-stage which comprises a start-pulse generator (12) for the emission of the start pulse (ST), an AND-gate (13), and a synchronising flip-flop (14).

6. An ultrasonic transmitter as claimed in Claim 5, characterised in that a first input of the AND-gate (13) is connected to the start-pulse generator (12) for the supply of the start pulses (ST), and that a second input of the AND-gate (13) is connected to the output (5) of the backwards counter (1), that the overflow pulses which are produced on the occasion of each zero transistion of the backwards counter (1) are fed via the AND-gate (13) to the input of the synchronising flip-flop (14), and that the start pulses (ST) which are fed via the AND-gate (13) to the synchronising flip-flop (14) and the overflow pulses which are fed from the output of the backwards counter (1) via the AND-gate (13) to the synchronising flip-flop (14) are synchronised by the synchronising flip-flop (14) with the pulse train (PT) of the central clock-pulse generator (15) to form synchronised start pulses for the backwards counter (1).

7. An ultrasonic transmitter as claimed in Claim 6, characterised in that the counting pulse of the backwards counter (1) is simultaneously the clock pulse (PT) of the central clockpulse generator (15), where the central clock pulses (PT) are fed to the backwards counter (1), for the backwards counting, via a first electronic gate (9) which can be closed by a control signal of the pulse-length multiplexer (6) for the central clock pulses (PT) at the instant of the occurrence of the last pulse of the number of pulses input into the pulse-length multiplexer (6) via the second digital value (LW).

8. An ultrasonic transmitter as claimed in Claim 7, characterised in that the pulse-length multiplexer (6) also controls a second electronic gate (8) by which the synchronised start pulses are fed from the output of the synchronising flip-flop (14) to the first flip-flop circuit (10), whereas the synchronised start pulses of the second flip-flop circuit (11) are directly supplied.

9. An ultrasonic transmitter as claimed in Claim 8, characterised in that the second gate (8) can also be closed by the pulse-length multiplexer (6) as soon as the last pulse has occurred in accordance with the first digital value (LW) which has been input on the pulse-length multiplexer (6), so that immediately thereafter the first flip-flop circuit (10) is stopped in respect of synchronised start pulses of the synchronising flip-flop (14), whereas the second flip-flop circuit (11) also receives a final synchronised start pulse via the direct line.

10. An ultrasonic transmitter as claimed in one of Claims 1 to 9, characterised in that the transmitted pulse frequency ($f_s$) which occurs at the outputs (Q) of the flip-flop circuits (10, 11) is obtained in dependence upon the first digital value (FW) on the counter (1) and upon the central clock pulse (PT) of the clock-pulse generator (15) in accordance with the equation

$$f_s = \frac{PT}{2\,(FW + 1)}$$

## Revendications

1. Emetteur d'ultrasons pour produire des impulsions d'émission (S), dont chacune comprend un certain nombre d'impulsions d'excitation, pour un transducteur d'ultrasons (33), avec un compteur (1) attaqué par un générateur d'impulsions d'horloge (15) et pourvu d'une entrée de programmation (4), et avec un composant (6) à l'entrée de réglage (7) duquel est susceptible d'être réglé le nombre d'impulsions d'excitation par impulsion d'émission (S), caractérisé par le fait que le compteur (1) est un compteur programmable à l'entrée de programmation (4) duquel est susceptible d'être réglée la fréquence de répétition des impulsions ($f_s$) sous la forme d'une première valeur numérique (FW) susceptible d'être introduite, que le composant (6) est un dispositif de commande numérique agissant sur le compteur (1) et à l'entrée du réglage (7) duquel est réglable le nombre d'impulsions d'excitation à appliquer au transducteur d'ultrasons (33) pendant une impulsion d'émission, et, par voie de conséquence, également la durée totale de l'impulsion d'émission (S), sous la forme d'une seconde valeur numérique (LW) susceptible d'être introduite, que par la sortie du compteur (1) sont attaqués deux circuits multivibrateurs bistables (10, 11) qui fournissent par rapport à la ligne zéro des courbes asymétriques d'impulsions (S1, S2) décalées entre elles, de préférence d'une durée d'impulsion ($\tau$), et qu'à la cadence des deux courbes asymétriques d'impulsions (S1, S2) à la sortie d'un étage symétrique (17 à 32), et en fonction des deux valeurs numériques (FW, LW) susceptible d'être introduites, est produit un train d'impulsions rectangulaire de préférence symétrique par rapport à la ligne zéro et à nombre d'impulsions rectangulaires limité, appliqué en tant qu'impulsion d'émission (S) au transducteur d'ultrasons (3).

2. Emetteur d'ultrasons selon la revendication 1, caractérisé par le fait qu'il est prévu un second dispositif de commande numérique au niveau duquel est susceptible d'être réglé le taux d'impulsions $\tau/(T-\tau)$ de l'impulsion d'excitation sous la forme d'une valeur numérique susceptible d'être introduite.

3. Emetteur d'ultrasons selon la revendication 1, caractérisé par le fait que la durée d'impulsions ($\tau$) des impulsions des courbes asymétriques (S1, S2) est choisie à la demie longueur d'ondes ($\lambda/2$) de l'onde fondamentale du transducteur d'ultrasons (33).

4. Emetteur d'ultrasons selon la revendication 3, caractérisé par le fait que le taux d'impulsions des courbes asymétriques d'impulsions (S1, S2) est choisi à 1:1.

5. Emetteur d'ultrasons selon l'une des revendications 1 à 4, caractérisé par le fait que le compteur programmable (1) est un compteur des compteurs, qui, en fonction d'une impulsion de démarrage (ST) prend en charge la première valeur numérique (FW) qui est susceptible d'être introduite, et qui, après la prise en charge de la première valeur numérique (FW) est commandé en comptage à rebours, à la cadence (PT) du générateur d'impulsions d'horloge, étant noté qu'il est né, après chaque passage par la valeur zéro, une impulsion de dépassement, que le dispositif de commande numérique (6) est un multiplexeur à longueurs d'impulsions, dont l'entrée d'adresses représente l'entrée de réglage (7) pour la seconde valeur numérique (LW), et que sont associés au compteur (1) et au multiplexeur à longueurs d'impulsions (6) des portes électroniques (8, 9), les circuits à multivibrateurs bistables (10, 11) pour la division de fréquence, de même qu'un étage de démarrage qui comprend un générateur d'impulsions de démarrage (12) pour l'émission de l'impulsion de démarrage (ST), une porte ET (13) et un multivibrateur bistable de synchronisation (14).

6. Emetteur d'ultrasons selon la revendication 5, caractérisé par le fait qu'une première entrée de la porte ET (13) est reliée au générateur d'impulsions de démarrage (12) pour être chargée avec les impulsions de démarrage (ST) et qu'une seconde entrée de la porte ET (13) est reliée à la sortie (5) du compteur des compteurs (1), que les impulsions de dépassement dont chacune est produite au passage par le zéro du compteur des compteurs (1) sont appliquées par l'intermédiaire de la porte ET (13) à l'entrée du multivibrateur bistable de synchronisation (14), et que les impulsions de démarrage (ST) qui sont appliquées par l'intermédiaire de la porte ET (13) au multivibrateur bistable de synchronisation (14) et les impulsions de dépassement qui sont appliquées par la sortie du compteur des compteurs (1), par l'intermédiaire de la porte ET (13), au multivibrateur bistable de synchronisation (14), sont synchronisées, à l'aide du multivibrateur bistable de synchronisation (14) avec l'impulsion d'horloge (PT) du générateur d'impulsions d'horloge (15) en vue de l'obtention d'impulsions de démarrage synchronisées pour le compteur des compteurs (1).

7. Emetteur d'ultrasons selon la revendication 6, caractérisé par le fait que la cadence de comptage du compteur des compteurs (1) est en même temps l'impulsion d'horloge (PT) du générateur central d'impulsions d'horloge (15), et que les impulsions centrales d'horloge (PT) sont appliquées pour le comptage à rebours, au compteur des compteurs (1) par l'intermédiaire d'une première porte électronique (9) qui est susceptible d'être rendue non passante pour les impulsions centrales d'horloge (PT), par un signal de commande de multiplexeur à longueurs d'impulsions (6), à l'instant où se présente la dernière impulsion du nombre d'impulsions qui est introduit, par l'intermédiaire de la seconde valeur numérique (LW) dans le multiplexeur de longueurs d'impulsions (6).

8. Emetteur d'ultrasons selon la revendication 7, caractérisé par le fait que le multiplexeur à longueurs d'impulsions (6) commande également une seconde porte électronique (8) à l'aide de laquelle les impulsions de démarrage synchronisées provenant de la sortie du multivibrateur bistable de synchronisation (14) sont appliquées au premier circuit multivibrateur bistable (10), alors que les impulsions de démarrage synchronisées sont appliquées directement au second circuit multivibrateur bistable (11).

9. Emetteur d'ultrasons selon la revendication 8, caractérisé par le fait que la seconde porte (8) est également susceptible d'être bloquée par le multiplexeur à longueurs d'impulsions (6), dès que se présente la dernière impulsion qui correspond à la première valeur numérique (LW) introduite au niveau du multiplexeur à longueurs d'impulsions, en sorte que le premier circuit multivibrateur bistable (10) est immédiatement bloqué pour des impulsions de démarrage synchronisées du multivibrateur bistable de synchronisation (14), alors que le second circuit multivibrateur bistable (11) reçoit, par l'intermédiaire de la ligne directe, une toute dernière impulsion de démarrage synchronisée.

10. Emetteur d'ultrasons selon l'une des revendications 1 à 9, caractérisé par le fait que la fréquence des impulsions d'émission ($f_s$) qui sont présentent aux sorties (Q) des circuits multivibrateur bistable (10, 11) satisfait la relation

$$f_s = \frac{PT}{2\,(FW + 1)}$$

en fonction de la première valeur numérique (FW) au niveau du compteur (1) et de l'impulsion d'horloge centrale (PT) du générateur d'impulsions d'horloge (15).

FIG 1

FIG 2

FIG 3